# NEUE EUROPÄISCHE PATENTSCHRIFT

(11) **EP 1 901 598 B2**
(45) Veröffentlichungstag und Bekanntmachung des Hinweises auf die Entscheidung über den Einspruch: **29.02.2012**
(45) Hinweis auf die Patenterteilung: 05.11.2008
(21) Anmeldenummer: 06019090.7
(22) Anmeldetag: 12.09.2006
(51) Int. Cl.: H05K 7/14

(54) **Automatisierungsgerät**
Automation device
Appareil d'automatisation

(43) Veröffentlichungstag der Anmeldung: 19.03.2008
(73) Patentinhaber: SIEMENS AKTIENGESELLSCHAFT, 80333 München (DE)
(72) Erfinder: Klamm, Arnold, 76870 Kandel (DE)

(56) Entgegenhaltungen:
- EP-A- 1 278 275
- EP-A1- 0 272 189
- EP-A1- 0 364 618
- EP-A1- 0 527 247
- DE-A1- 3 740 290
- DE-A1- 19 610 559
- DE-U1- 8 804 649
- US-A- 4 790 762

## Beschreibung

Die Erfindung betrifft ein Automatisierungsgerät, welches mehrere Baugruppen aufweist, mit einer Gehäusekapsel für jede Baugruppe, die mit wenigstens einer Rückwand versehen ist, und mit einem an der Rückwand jeder Baugruppe angeordneten Baugruppen-Busmodulteil, welches mit einer Leiterplatte verbunden ist und welches mit einem Verbindungs-Busmodulteil elektrisch und mechanisch zusammenwirkt, das eine Busverbindung mit einer benachbarten Baugruppe herstellt, wobei die Baugruppen auf eine Tragschiene montiert sind.

Ein derartiges Automatisierungsgerät ist aus der DE 42 25 573 C2 bekannt. Jede Baugruppe dieses Automatisierungsgerätes weist ein im Wesentlichen U-förmiges Baugruppen-Busmodulteil auf, welches zur Herstellung einer Busverbindung mit einer benachbarten Baugruppe mit einem ebenfalls im Wesentlichen U-förmigen Verbindungs-Busmodulteil elektrisch und mechanisch verbunden ist. Die Basis und die Schenkel eines Verbindungs-Busmodulteils überbrücken dabei den Abstand zwischen einem Schenkel eines Baugruppen-Busmodulteils von einem benachbarten Schenkel einer benachbarten Baugruppe. Der Zusammenbau des Automatisierungsgerätes erfolgt vorzugsweise in der Art und Weise, dass jeweils in den rechten Schenkel der Baugruppen ein Schenkel des Verbindungs-Busmodulteils eingesetzt wird, so dass der rechte Schenkel des jeweiligen Verbindungs-Busmodulteils rechts hinten aus den Baugruppen hervorragt. Anschließend werden die Baugruppen nach- und nebeneinander auf eine Tragschiene aufgeschwenkt, wobei durch das Aufschwenken zwangsweise die elektrische Verbindung benachbarter Baugruppen hergestellt wird.

EP 0 025 209 A2 beschreibt eine Basline-Anordnung, welche zur elektrischen Verbindung von Baugruppen vorgesehen ist.

Der vorliegenden Erfindung liegt die Aufgabe zugrunde, ein Automatisierungsgerät der eingangs genannten Art zu schaffen, dessen Zusammenbau vereinfacht wird.

Diese Aufgabe wird durch die im kennzeichnenden Teil des Anspruchs 1 angegebenen Maßnahmen gelöst.

Durch einen derartigen Träger wird eine Montage der Baugruppen vereinfacht. Der mit den Verbindungs-Busmodulteilen versehene Träger wird z. B. zunächst an der Tragschiene positioniert und durch das Aufschwenken von zwei Baugruppen auf der Tragschiene festgehalten. Durch das Aufschwenken dieser Baugruppen greifen deren Baugruppen-Busmodulteile in die entsprechenden Verbindungs-Busmodulteile des Trägers ein, wodurch der Träger durch diese Baugruppen festgehalten wird. Auf einen derartig positionierten und festgehaltenen Träger können anschließend die restlichen Baugruppen aufgeschwenkt werden. Eine Vormontage eines Verbindungs-Busmodulteils vor dem Aufschwenken einer Baugruppe ist nicht mehr erforderlich. Besonders vorteilhaft ist ferner, dass einzelne Verbindungs-Busmodulteile im Falle einer Demontage von Baugruppen nicht verloren gehen können, da jedes Verbindungs-Busmodulteil auf dem Träger in seiner Position gehalten wird und auf diese Verbindungs-Busmodulteile neue Baugruppen gesteckt bzw. aufgeschwenkt werden können.

Dadurch, dass der Träger mit Sollbruchstellen versehen ist kann die Länge des Trägers leicht an die Anzahl der benötigten Baugruppen des Automatisierungsgerätes angepasst werden.

Durch einen Träger gemäß den im Anspruch 2 angegebenen Maßnahmen wird vermieden, dass z. B. ein Servicetechniker eine Vielzahl von Verbindungs-Busmodulteilen separat mitführen bzw. dass ein Kunde im Rahmen einer Ersatzteilhaltung eine Vielzahl von Einzelteilen in Form von einzelnen Verbindungs-Busmodulteilen lagern muss. Ein derartiger Träger ist einfacher zu handhaben und einfacher als separates Teil zu vermarkten.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen in schematischer Darstellung:
- Figur 1: ein modulares Automatisierungsgerät mit einem Verbindungs-Busmodulteile aufweisenden Träger,
- Figur 2: auf einem Träger gehaltene Verbindungs-Busmodulteile und
- Figur 3: ein bekanntes modulares Automatisierungsgerät.

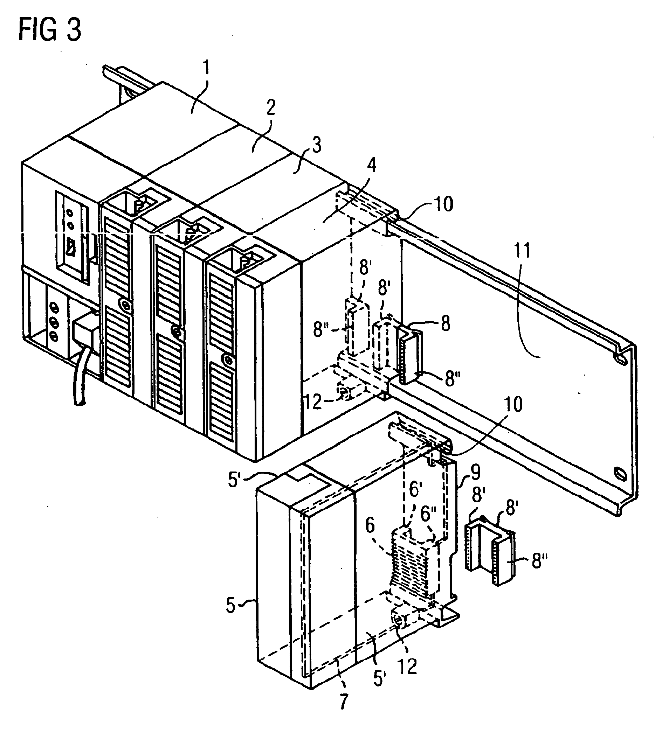

Es wird zunächst auf Figur 3 verwiesen, in welcher ein an sich bekanntes modulares Automatisierungsgerät dargestellt ist. Dieses weist Baugruppen 1 bis 5 auf, von denen die Baugruppe 1 eine Zentraleinheit ist und die Baugruppen 2 bis 5 als Peripheriebaugruppen ausgestaltet sind. Jede der Baugruppen 1 bis 5 ist mit einem im Wesentlichen U-förmigen Baugruppen-Busmodulteil 6 versehen, welches mit einer Leiterplatte 7 elektrisch verbunden ist und mit einem dazu im Wesentlichen symmetrisch aufgebauten U-förmigen Verbindungs-Busmodulteil 8 bei zusammengebautem Automatisierungsgerät elektrisch und mechanisch in Wirkverbindung steht. Die Baugruppen 1 bis 5 sind zum Schutz vor Beschädigung der in den Baugruppen 1 bis 5 enthaltenen Leiterplatte 7 als umhüllende Gehäusekapsel ausgebildet. Jeder Schenkel 8', 8'' des Verbindungs-Busmodulteils 8 kann in jeden Schenkel 6', 6" des Baugruppen-Busmodulteils 6 eingesetzt werden, wodurch eine Busverbindung entsteht. Das Baugruppen-Busmodulteil 6 ist derart ausgestaltet, dass die Schenkel 6', 6'' unabhängig von der Breite der Baugruppen, z. B. der Baugruppe 5, stets den gleichen Abstand zur nächstliegenden Seitenwand, z. B. den Seitenwänden 5', 5'' der Baugruppe 5, aufweisen. Das Verbindungs-Busmodulteil 8 ist derart ausgestaltet, dass es genau den Abstand zwischen zwei Schenkeln 6', 6" zweier benachbarter Baugruppen überbrückt. Der Zusammenbau des Automatisierungsgerätes erfolgt z. B. in der Art und Weise, dass jeweils in den rechten Schenkel 6" der Baugruppen 1 bis 5 der linke Schenkel 8' des Verbindungs-Busmodulteils 8 eingesetzt wird, so dass der rechte Schenkel 8" des jeweiligen Verbindungs-Busmodulteils 8 rechts hinten aus den Baugruppen 1 bis 5 hervorragt. Anschließend werden die Baugruppen 1 bis 5 mittels einer an einer Rückwand 9 der Baugruppen 1 bis 5 angeordneten Hakvorrichtung 10 nach- und nebeneinander auf eine Tragschiene 11 aufgeschwenkt, wobei durch das Aufschwenken zwangsweise die elektrische Verbindung benachbarter Baugruppen hergestellt wird, wobei nach dem Aufschwenken die Baugruppen 1 bis 5 durch eine Schraubverbindung 12 auf der Tragschiene 11 gesichert werden. Die Busverbindung wird also dadurch aufgebaut, dass abwechselnd je ein Baugruppen-Busmodulteil 6 und ein Verbindungs-Busmodulteil 8 elektrisch und mechanisch miteinander verbunden sind.
Auf ein Einsetzen eines Verbindungs-Busmodulteils in eine Baugruppe vor dem Aufschwenken dieser Baugruppe kann verzichtet werden, indem die Verbindungs-Busmodulteile auf einen Träger angeordnet und auf diesem gehalten werden.

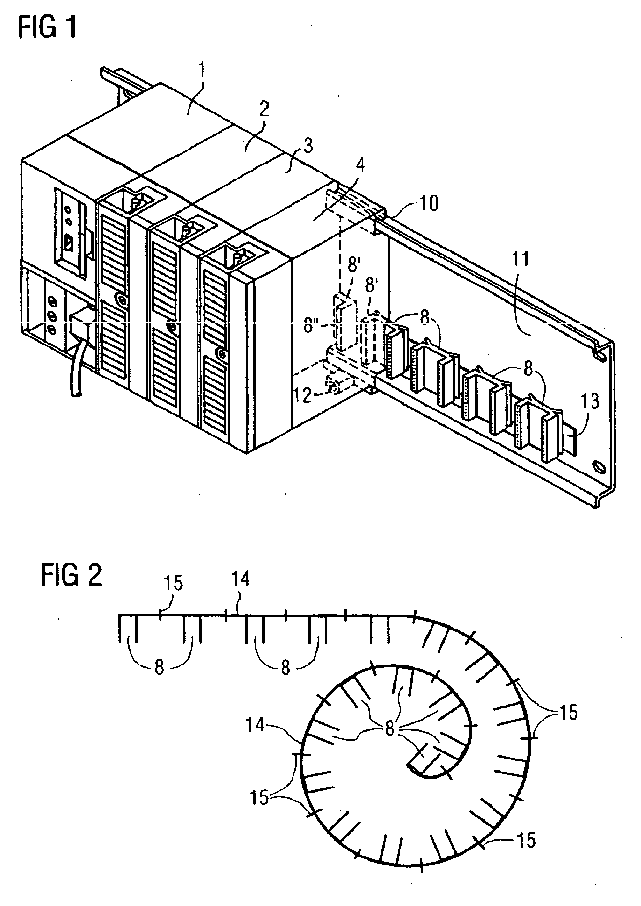

In diesem Zusammenhang wird auf Figur 1 verwiesen, in welcher ein modulares Automatisierungsgerät dargestellt ist. Die in den Figuren 1 und 3 dargestellten gleichen Teile sind mit gleichen Bezugszeichen versehen. Die Verbindungs-Busmodulteile werden auf einem Träger 13 gehalten, der auf der Tragschiene 11 angeordnet ist. Der Träger kann in einfacher Weise auf der Tragschiene 11 positioniert werden, indem beispielsweise die Baugruppen 1 und 4 auf die entsprechenden Verbindungs-Busmodulteile 8 gesteckt und anschließend die Baugruppen 1 und 4 mit dem Träger 13 auf die Tragschiene 11 aufgeschwenkt werden. Dadurch ist der Träger 13 auf der Tragschiene 11 positioniert und es können die restlichen Baugruppen auf die Tragschiene 11 aufgeschwenkt werden, wobei durch das Aufschwenken zwangsweise die elektrische Verbindung benachbarter Baugruppen hergestellt wird. Der Träger 13 ist mit Sollbruchstellen versehen, wodurch die Länge des Trägers 13 leicht an die Anzahl der benötigten Baugruppen des Automatisierungsgerätes angepasst werden kann. Im dargestellten Ausführungsbeispiel weist der Träger 13 sieben Verbindungs-Busmodulteile auf und die Tragschiene 11 ist somit zur Aufnahme von acht Baugruppen vorgesehen.

Durch den Träger wird vermieden, dass einerseits ein Servicetechniker eine Vielzahl von Verbindungs-Busmodulteilen separat mitführen und dass andererseits ein Kunde im Rahmen einer Ersatzteilhaltung eine Vielzahl von Einzelteilen in Form von einzelnen Verbindungs-Busmodulteilen lagern muss. Die Verbindungs-Busmodulteile 8 sind z. B. auf einem Träger in Form eines Kunststoffstreifens 14 (Figur 2) angeklebt, welcher spiralförmig aufgerollt sein kann und welcher in einem Rasterabstand mit Sollbruchstellen 15 versehen ist. Dadurch ist es im Rahmen einer Montage vor Ort leicht möglich, einen Streifen mit einer gewünschten Anzahl von Verbindungs-Busmodulteilen 8 abzubrechen. Die Baugruppen können demontiert werden, ohne dass dabei Verbindungs-Busmodulteile 8 verloren gehen.

## Patentansprüche

1. Automatisierungsgerät, welches mehrere Baugruppen (1, 2, ...) aufweist, mit
- einer Gehäusekapsel für jede Baugruppe (1, 2, ...), die mit wenigstens einer Rückwand (9) versehen ist,
- einem an der Rückwand (9) jeder Baugruppe (1, 2, ...) angeordneten Baugruppen-Busmodulteil (6), welches mit einer Leiterplatte (7) verbunden ist und welches mit einem Verbindungs-Busmodulteil (8) elektrisch und mechanisch zusammenwirkt, das eine Busverbindung mit einer benachbarten Baugruppe herstellt, wobei die Baugruppen-Busmodulteile (6) und die Verbindungs-Busmodulteile (8) im Wesentlichen U-förmig sind und zwei Schenkel (6', 6"; 8', 8" ) und eine Basis sowie mehrere Buskontakte aufweisen,
wobei die Baugruppen (1, 2, ...) auf eine Tragschiene (11) montiert sind,
**dadurch gekennzeichnet,**
- **dass** die Verbindungs-Busmodulteile (8) auf einem auf der Tragschiene (11) angeordneten Träger (13; 14) gehalten sind, wobei jeweils die Basis der im Wesentlichen U-förmigen Verbindungs-Busmodulteile (8) auf dem Träger (13; 14) befestigt ist, und
- **dass** der Träger (13; 14) mit Sollbruchstellen (15) versehen ist.

2. Träger mit mehreren Verbindungs-Busmodulteilen (8), welcher für einen Einsatz in einem Automatisierungsgerät nach Anspruch 1 geeignet ist, **dadurch gekennzeichnet, dass** der Träger (13; 14) mit Sollbruchstellen (15) versehen ist.

## Claims

1. Automation device having a number of subassemblies (1, 2, ...) with
- a housing capsule for each subassembly (1, 2, ...), which is provided with at least one rear wall (9),
- a subassembly bus module part (6) arranged on the rear wall (9) of each subassembly (1, 2, ...), which is connected to a further printed circuit board (7) and which interacts electrically and mechanically with a connection bus module part (8), which establishes a bus connection with an adjacent module, with the subassembly bus module parts (6) and the connection bus module parts (8) being essentially U-shaped and having two legs (6', 6"; 8', 8") and a base as well as a number of bus contacts,
with the modules (1, 2, ...) being mounted on a mounting rail (11),
**characterised in that**,
- the connection bus module parts (8) are held on a mount (13; 14) arranged on the mounting rail (11), with the base of the essentially U-shaped bus module parts (8) being attached to the mount (13; 14) in each case, and
- the mount (13; 14) being provided with predetermined breaking points (15).

2. Mount with a number of connection bus parts (8), which is suitable for use in an automation device according to claim 1, **characterised in that** the mount (13; 14) is provided with predetermined breaking points (15).

## Revendications

1. Appareil d'automatisation, qui comporte plusieurs modules ( 1, 2, ... ), comprenant
- un encapsulage par boîtier pour chaque module ( 1, 2, ... ), qui est pourvu d'au moins une paroi ( 9 ) arrière,
- une partie ( 6 ) module-module de bus, disposée sur la paroi ( 9 ) arrière de chaque module ( 1, 2, ... ), qui est reliée à une plaquette (7) à circuits imprimés et qui coopère électriquement et mécaniquement avec une partie ( 8 ) liaison-module de bus, qui ménage une liaison par bus avec un module voisin, les parties ( 6 ) modules-module de bus et les parties (8) liaison-module de bus étant sensiblement en forme de U et ayant deux branches ( 6', 6" ; ; 8', 8" ) et une base et ainsi que plusieurs contacts de bus,
les modules ( 1, 2, ... ) étant montés sur un rail ( 11 ) porteur,
**caractérisé**
- **en ce que** les parties ( 8 ) de liaison-module de bus sont maintenues sur un support ( 13 ; 14 ) monté sur le rail ( 11 ) porteur, respectivement la base des parties ( 8 ) de liaison-module de bus sensiblement en forme de U étant fixée sur le support ( 13 ; 14 ), et
- **en ce que** le support est pourvu d'emplacements ( 15 ) destinés à se rompre.

2. Support ayant plusieurs parties ( 8 ) de liaison-module de bus, qui convient en vue d'être utilisé dans un appareil d'automatisation suivant la revendication 1, **caractérisé en ce que** le support ( 13 ; 14 ) est pourvu d'emplacements ( 15 ) destinés à se rompre.
